# FASCICULE DE BREVET EUROPEEN

(11) **EP 2 338 175 B1**
(45) Date de publication et mention de la délivrance du brevet: **03.04.2019**
(21) Numéro de dépôt: 09756331.6
(22) Date de dépôt: 21.10.2009
(51) Int. Cl.: H01L 25/065, H01L 21/60, H01L 23/48, H01L 23/49, H01L 21/98

(54) **ASSEMBLAGE D'UNE PUCE MICROÉLECTRONIQUE À RAINURE AVEC UN ÉLÉMENT FILAIRE SOUS FORME DE TORON ET PROCÉDÉ D'ASSEMBLAGE**
BAUGRUPPE MIT EINEM MIT EINER RILLE VERSEHENEN MIKROELEKTRONISCHEN CHIP UND MIT EINEM TOROID-DRAHTELEMENT SOWIE VERFAHREN ZU DEREN ZUSAMMENBAU
ASSEMBLY OF A GROOVED MICROELECTRONIC CHIP WITH A TOROIDAL WIRE ELEMENT AND METHOD OF ASSEMBLING IT

(30) Priorité: 21.10.2008 FR 0805832
(43) Date de publication de la demande: 29.06.2011
(73) Titulaire: Commissariat à l'Énergie Atomique et aux Énergies Alternatives, 75015 Paris (FR)
(72) Inventeur: BRUN, Jean, F-38800 Champagnier (FR); VERRUN, Sophie, F-38100 Grenoble (FR); VICARD, Dominique, F-38330 Saint Nazaire les Eymes (FR)
(74) Mandataire: Talbot, Alexandre
(86) Numéro de dépôt international: PCT/FR2009/001231
(87) Numéro de publication internationale: WO 2010/046563

(56) Documents cités:
- WO-A-2008/025889
- WO-A1-2009/112644
- FR-A1- 2 917 895
- US-A1- 2005 223 552

## Description

### Domaine technique de l'invention

L'invention est relative à un assemblage d'au moins une puce microélectronique avec un élément filaire, la puce comportant une rainure longitudinale d'encastrement de l'élément filaire.

### État de la technique

De nombreuses techniques existent aujourd'hui pour connecter mécaniquement et électriquement des puces microélectroniques entre elles. Une technique conventionnelle consiste, une fois les puces formées sur un substrat et libérées par sciage, à réaliser une connexion mécanique rigide entre les puces. Les puces, alors fixées sur un support rigide, sont ensuite connectées électriquement avant qu'un enrobage de protection ne soit formé. Cette approche, consistant à réaliser la connexion sur un support rigide, est classiquement utilisée lorsqu'il existe une grande complexité dans la connexion des puces. Cependant, cette approche a pour principal inconvénient d'utiliser un support mécanique rigide qui est particulièrement mal adapté à une intégration dans des structures souples.

Le document WO2008/025889 de la demanderesse décrit, comme l'illustre la figure 1, une puce microélectronique comportant deux faces principales parallèles 1, 2 et des faces latérales 3a, 3b reliant les deux faces principales 1 et 2. Au moins une des faces latérales 3a, 3b comporte une rainure 4 munie d'un élément de connexion électrique (non représenté) et formant un logement pour un élément filaire 5. L'élément de connexion électrique est réalisé par métallisation de la rainure 4. L'élément filaire 5 est ensuite solidarisé à la rainure 4 par soudure avec apport de matériau, par électrolyse, par collage, ou par encastrement. Si la puce microélectronique a besoin de deux bus de données indépendants, cela nécessite de réaliser deux rainures sur deux faces latérales indépendantes, chaque rainure 4 comportant un élément de connexion électrique distinct. Ainsi les deux bus de données sont réalisés par l'association de deux éléments filaires 5 électriquement conducteurs disposés dans deux rainures distinctes. Ceci ne pose pas de problèmes de réalisation tant que l'on ne multiplie pas le nombre de bus de données. En effet, si la puce a besoin d'une dizaine de connexions distinctes, il ne sera pas possible de réaliser ces connexions à moins de rajouter des bornes de connexion sur les faces principales 1 et 2 surchargeant la puce microélectronique et réduisant la souplesse de l'assemblage. De plus, dans le cas où un assemblage comporte plusieurs puces reliées les unes aux autres par un élément filaire, ces puces sont obligées de partager un même bus de données.

### Objet de l'invention

L'invention vise à réaliser un assemblage entre un élément filaire et une puce ne présentant pas les inconvénients de l'art antérieur.

On tend vers cet objectif par un assemblage selon la revendication 1.

Selon une première variante, l'assemblage comporte au moins deux puces reliées par le toron, un fil électriquement conducteur du toron étant en contact avec un plot d'une seule puce.

Selon une seconde variante, un fil électriquement conducteur du toron est en contact avec un plot d'au moins deux puces.

Selon une autre variante, ladite puce comporte autant de plots que de fils électriquement conducteurs distincts du toron, chaque plot étant en contact électrique avec un fil associé du toron.

Selon un développement, chaque plot est disposé sur au moins une première paroi latérale de la rainure et constitue des moyens de blocage du toron dans la rainure par pincement du toron entre chaque plot et une seconde paroi latérale de la rainure opposée audit plot.

L'invention vise également un procédé de réalisation d'un assemblage d'une puce microélectronique à rainure avec un élément filaire sous forme de toron. Ce procédé est décrit dans la revendication 7.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une puce microélectronique reliée à des éléments filaires par encastrement dans une rainure selon l'art antérieur.
La figure 2 illustre, en vue de côté, un exemple de puce microélectronique utilisée pour réaliser l'assemblage selon l'invention.
La figure 3 illustre, selon une coupe A-A de la figure 2, une puce microélectronique.
La figure 4 illustre, selon une vue B-B de la figure 2, une puce microélectronique dans laquelle un élément filaire sous forme de toron a été inséré.
La figure 5 illustre, selon une coupe similaire à la coupe A-A de la figure 2, une variante de réalisation des plots de connexion dans la rainure.
Les figures 6 et 7 illustrent un procédé de raccordement d'une puce microélectronique avec un élément filaire.
Les figures 8, 9 et 10 illustrent schématiquement des types de connexions électriques possibles d'un assemblage.

### Description d'un mode préférentiel de l'invention

Les puces microélectroniques peuvent être utilisées pour former un assemblage de puces sous forme de guirlandes. Les puces sont alors reliées entre elles par un élément filaire. Les puces utilisées dans ce genre d'application ont, de préférence, des dimensions inférieures à 5 mm, voire inférieures à 1 mm. En effet, un assemblage selon l'invention est plus particulièrement intéressant pour des puces de petites dimensions car elle permet une manipulation et une connexion aisée de ces dernières.

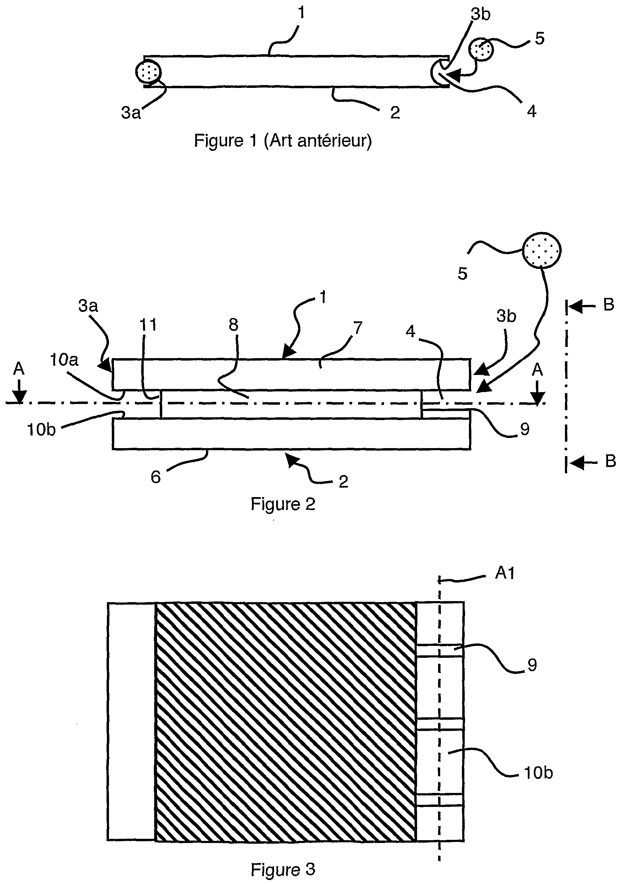

Comme l'illustre la figure 2, une telle puce microélectronique comporte, à titre d'exemple, deux faces principales parallèles 1, 2 et des faces latérales 3a et 3b reliant les deux faces principales 1 et 2. Au moins une des faces latérales 3a, 3b comporte une rainure 4 longitudinale d'encastrement de l'élément filaire 5. La rainure 4 est délimitée par deux parois latérales 10a et 10b pouvant être reliées au fond de la rainure 4 par un pan 11.

Ce type de puce peut se présenter sous la forme d'un assemblage de deux composants microélectroniques, ou d'un composant microélectronique 6 et d'une contreplaque 7 comme sur la figure 2. Les deux composants, ou le composant et la contreplaque, sont sensiblement de mêmes dimensions et sont reliés par une entretoise 8. L'entretoise 8 étant de dimensions inférieures à celles du composant microélectronique 6, son placement permet d'obtenir naturellement au moins une rainure 4. Une puce peut aussi comporter, comme l'illustre la figure 2, deux rainures se situant de part et d'autre de l'entretoise 8. L'assemblage avec l'entretoise 8 permet d'obtenir les rainures 4 par montage de la puce, en évitant une étape d'usinage, complexe et risquée pour l'intégrité de la puce lors de la fabrication. Les rainures 4 sont alors conformées en U et délimitées par les deux parois latérales 10a et 10b, pouvant être sensiblement parallèles, reliées par le pan 11 formant le fond de la rainure 4. La contreplaque 7 peut être réalisée en verre, matériau composite, etc.

Une puce est destinée à être reliée par un élément filaire 5 constitué d'au moins deux fils électriquement conducteurs, isolés l'un de l'autre, formant un toron. Par « toron » on entend un assemblage d'au moins deux fils torsadés l'un avec l'autre. Chaque rainure 4 de chaque puce comporte alors au moins un plot 9 (« bump » en anglais) électriquement conducteur, le plot 9 étant, après l'assemblage de d'élément filaire 5 avec la puce microélectronique, en contact électrique avec une zone dénudée d'un seul des fils électriquement conducteurs du toron. Une fois en place, l'élément filaire 5 peut être solidarisé de la rainure par simple collage, par exemple par l'introduction d'une colle époxy dans la rainure.

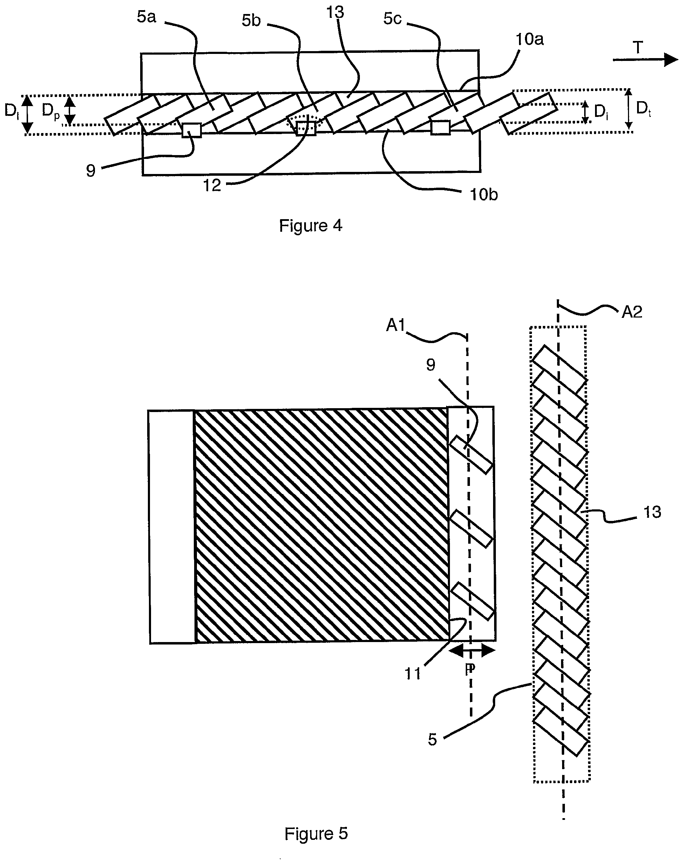

De préférence, l'isolation électrique des fils électriquement conducteurs constituant le toron est réalisée par un dépôt isolant qui revêt chaque fil électriquement conducteur. Ce dépôt isolant peut être organique, par exemple un thermoplastique, une colle époxy, et/ou minéral, par exemple le SiO₂ ou l'alumine. Ainsi, lorsque le toron est inséré dans la rainure 4, le dépôt isolant recouvrant chaque fil électriquement conducteur est percé lors de la sollicitation du fil avec son plot 9. Le fil est alors en contact électrique avec le plot correspondant au niveau d'une zone dénudée 12 (figure 4) et isolé en dehors de cette zone 12. La sollicitation de l'élément filaire 5 contre le plot 9 correspondant lors de l'insertion de l'élément filaire permet de rayer le fil au niveau de la zone de contact 12 et ainsi de dénuder automatiquement une zone du fil.

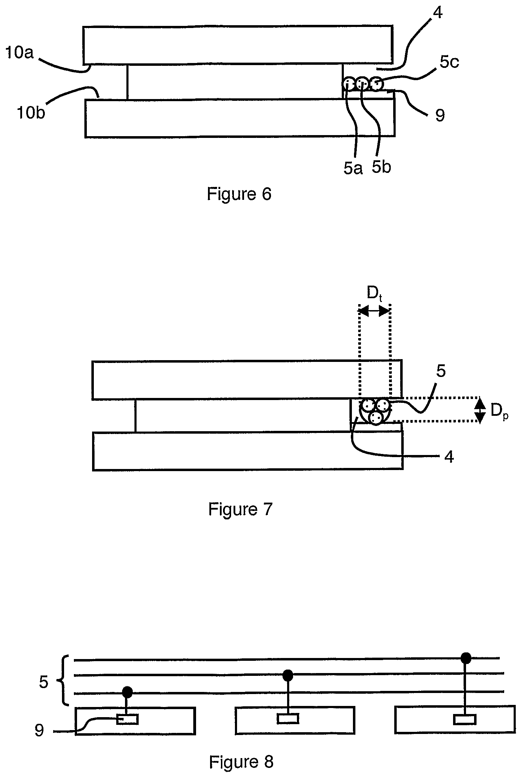

Un assemblage peut comporter au moins deux puces reliées par le toron. Dans une situation où l'on cherche à ce que chaque puce soit reliée à son propre fil, chaque fil électriquement conducteur du toron est en contact avec un plot 9 d'une seule puce respective. Selon l'exemple particulier illustré à la figure 8, trois puces sont reliées par un élément filaire 5 sous forme de toron comportant trois fils électriquement conducteurs, chaque fil électriquement conducteur étant relié électriquement à une seule puce par l'intermédiaire du plot 9 de connexion. Une puce comporte alors un bus de données totalement indépendant. Bien entendu, ce principe peut s'appliquer à une pluralité de puces, le toron comportant alors autant de fils électriquement conducteurs que l'assemblage comporte de puces.

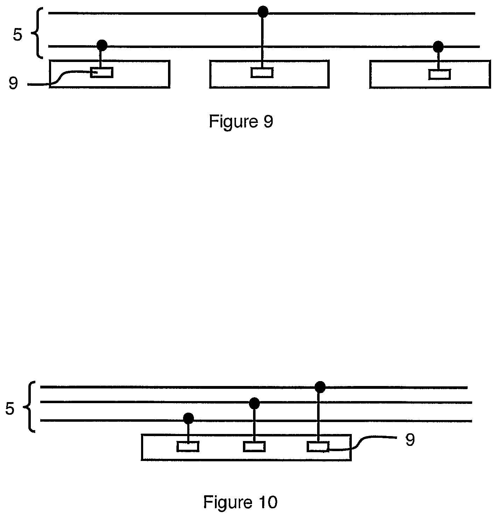

Selon une variante, un fil électriquement conducteur du toron est en contact électrique avec un plot 9 d'au moins deux puces. Ainsi, comme l'illustre la figure 9, l'assemblage comporte trois puces et les puces de chaque extrémité de l'assemblage partagent un même fil électriquement conducteur servant par exemple de bus de données commun.

Selon une autre variante, une puce peut comporter autant de plots que de fils électriquement conducteurs du toron. Dans le cas de l'exemple particulier illustré à la figure 10, la puce comporte trois plots 9 et le toron 5 est constitué par trois fils électriquement conducteurs. Chaque plot 9 est en contact électrique avec un seul fil électriquement conducteur du toron permettant de multiplier les connexions pour une même puce.

Bien entendu, les trois exemples d'assemblage décrits ci-dessus ne sont pas limitatifs. En effet, tout type d'assemblage et de connexion peut être envisagé, les différents types peuvent notamment être utilisés en combinaison. Un fil électriquement conducteur constitutif du toron peut correspondre à un bus de données ou à une connexion d'alimentation.

Dans le cas où le dépôt isolant est un thermo-plastique, lorsque le toron a été inséré dans la rainure 4 et que les plots 9 sont en contact intime avec le fil correspondant, l'assemblage obtenu peut être chauffé afin d'assurer le blocage du toron dans la rainure 4, tout en conservant l'isolation électrique entre les différents fils constituant le toron.

Selon un développement illustré aux figures 2 à 5, les plots 9 sont disposés sur au moins l'une des parois latérales 10a, 10b de la rainure 4 et constituent des moyens de blocage par pincement du toron entre chaque plot 9 et la paroi latérale 10a de la rainure 4 opposée au plot 9 correspondant. Les plots 9 agissent comme une pince mécanique lorsqu'un toron est inséré dans la rainure 4. Ainsi, comme illustré à la figure 4, le toron comporte, à titre d'exemple, trois fils électriquement conducteurs 5a, 5b et 5c. La torsion de ces trois fils pour réaliser le toron a généré naturellement des interstices 13 entre les fils électriquement conducteurs enroulés en hélice autours d'un axe longitudinal du toron A₂ (figure 5). Les interstices 13 représentent des espaces vides entre deux fils adjacents au niveau de la surface extérieure du toron.

Le diamètre Dᵢ du toron au niveau des interstices 13 est inférieur au diamètre Dₜ maximal du toron, et inférieur à la distance Dₚ séparant les plots 9 de la paroi latérale 10a de la rainure opposée auxdits plots 9. Le diamètre Dₜ maximal du toron est supérieur à la distance Dₚ tout en restant inférieur ou égal à la distance Dₗ séparant les deux parois latérales 10a et 10b. Ainsi, lors de l'insertion du toron dans la rainure 4, le toron est, de préférence, placé de manière à ce que les plots 9 soient en regard des interstices 13, permettant une insertion sans force du toron dans la rainure 4. Pour cela, les interstices 13 doivent pouvoir recevoir sans frottement un plot 9. Une fois le toron inséré, ce dernier subit une force de traction T, réalisée selon un axe longitudinal A₁ (figure 3) de la rainure 4, permettant aux fils 5a, 5b et 5c du toron de venir en contact (zone 12) avec leurs plots 9 respectifs et d'assurer la dénudation des fils électriquement conducteurs du toron au niveau de la zone 12 de contact. La traction permet aussi au toron d'être bloqué par pincement entre les plots 9, placés sur la paroi latérale 10b de la rainure 4, et la paroi latérale 10a de la rainure 4 opposée aux plots 9. Le coincement du toron par pincement permet son maintien dans la rainure 4.

Afin qu'un coincement par pincement soit efficace, il est préférable que le matériau composant les fils électriquement conducteurs du toron soit plus malléable que les matériaux constituant les plots 9 et la paroi latérale 10a de la rainure 4 opposée aux plots 9 ou inversement. À titre d'exemple, les fils peuvent être réalisés en argent, aluminium ou cuivre. La paroi latérale opposée au plot peut être constituée de silicium, de verre, d'époxy ou éventuellement de couches en oxyde de silicium ou nitrure de silicium dans des épaisseurs comprises entre 500 et 5µm. Les plots peuvent être réalisés en nickel, en cuivre ou en tungstène recouvert d'un film d'or.

Les plots 9 situés au niveau de la rainure 4 peuvent se présenter sous différentes formes. Par exemple, comme illustré à la figure 5, ils peuvent avoir une forme allongée et être agencés de manière inclinée par rapport à l'axe longitudinal A₁ de la rainure 4. De préférence, l'inclinaison des plots 9 est parallèle à l'inclinaison locale des interstices 13 du toron pour faciliter l'insertion du toron, sans force, dans la rainure 4. L'inclinaison des plots 9 dépend alors du pas de la torsade du toron. En effet, plus le toron est torsadé plus le pas de la torsade devient faible, c'est-à-dire que l'axe local des interstices tend à se rapprocher de la perpendiculaire selon l'axe longitudinal A₂ du toron. Le blocage du toron dans la rainure 4 est ensuite réalisé par traction du toron. Comme précédemment décrit, la traction permet de pincer le toron entre chaque plot 9 et la paroi latérale 10a de la rainure 4 opposée au plot 9. L'utilisation de plots 9 inclinés permet, lors de la traction, de plaquer naturellement le toron contre le fond de la rainure 4. De plus, la traction du toron permet au plot 9 d'inciser le dépôt isolant du fil électriquement conducteur correspondant et de créer le contact au niveau de l'interface entre le plot 9 et le fil électriquement conducteur correspondant.

Afin d'améliorer le contact entre le fil et son plot 9 au niveau de la zone de contact 12, les plots 9 sont de préférence acérés pour favoriser la dénudation des fils et la pénétration.

La rainure peut comporter certains plots destinés uniquement à améliorer le blocage du toron dans la rainure par pincement entre le plot 9 et la paroi latérale 10a de la rainure 4 opposée audit plot 9. C'est-à-dire que ces plots ne sont pas actifs.

Le toron peut aussi comporter des brins non conducteurs pour augmenter la résistance de l'assemblage.

Dans le cas où la puce microélectronique est composée de deux composants électroniques 6, une rainure peut comporter des plots 9 sur chacune de ses parois latérales 10a et 10b. Les composants électroniques peuvent alors partager certains bus de données ou être reliés distinctement l'un de l'autre.

De manière générale, le procédé d'assemblage comporte la formation d'un toron encastré dans la rainure 4. Le toron est bloqué par pincement entre chaque plot 9 et la paroi latérale opposée 10a. Le toron est dénudé au niveau d'une zone 12 du fil électriquement conducteur destiné à venir en contact avec ledit plot.

La dénudation est soit provoquée par l'encastrement lui-même, c'est-à-dire que le toron est encastré et pincé lors de son insertion dans la rainure 4, soit après encastrement du toron dans la rainure par traction de ce dernier selon l'axe longitudinal A1 de la rainure.

Selon un développement, la dénudation est réalisée après l'encastrement du toron dans la rainure par traction de ce dernier selon l'axe longitudinal A1 de la rainure.

Selon une variante, le procédé de réalisation de l'assemblage comporte l'insertion des fils électriquement conducteurs dans la rainure 4 entre chaque plot 9 électriquement conducteur et la paroi latérale opposée 10a. Ensuite, une torsion des fils permet de former le toron directement dans la rainure 4. Enfin, une traction longitudinale du toron permet de former des zones dénudées sur chaque fil, permettant la mise en contact électrique d'un fil électriquement conducteur avec un plot 9 associé. Concomitamment à la dénudation, la traction permet de bloquer le toron par pincement entre le plot 9 et la deuxième paroi latérale 10a de la rainure opposée audit plot. Un exemple particulier est illustré à l'aide des figures 6 et 7. Ainsi, la puce microélectronique comporte trois plots allongés dont la longueur est inférieure ou égale à la profondeur P de la rainure 4. Ces plots sont perpendiculaires au pan 11 formant le fond de la rainure 4. Selon l'exemple, trois fils 5a, 5b, 5c électriquement conducteurs et isolés électriquement les uns des autres sont insérés côte à côte dans la rainure 4 (figure 6). Le diamètre de chaque fil 5a, 5b, 5c étant inférieur à la distance Dₚ séparant le plot 9 de la paroi latérale 10a opposée, les fils 5a, 5b, 5c sont insérés sans effort dans la rainure 4. Les trois fils sont ensuite torsadés directement dans la rainure 4 pour former le toron (figure 7). L'effort exercé entre les fils lors de la réalisation du toron suffit à produire une force qui tend à plaquer les fils conducteurs contre les plots 9 à connecter. Le pas de la torsade est adapté de manière à ce que chaque fil vienne en contact avec un plot distinct. La dénudation sur une zone de chaque fil se fait ensuite par la traction T du toron selon l'axe longitudinal A1 de la rainure 4. La traction permet aussi de bloquer le toron par pincement entre chaque plot 9 et la paroi latérale 10a de la rainure 4 opposée audit plot 9.

Avantageusement, la liaison entre un fil et un plot 9 peut être renforcée par voie chimique ou électrochimique. L'encastrement d'un toron dans une rainure 4 peut lui aussi être consolidé par électrolyse ou par insertion d'une colle époxy électriquement isolante dans la rainure.

De nombreuses variantes et modifications des modes de réalisation décrits ici apparaîtront à l'homme du métier. On a décrit à titre d'exemple des plots 9 réalisés sur les faces latérales de la rainure pour établir le contact électrique avec les fils du toron. Dans un mode de réalisation hors de l'invention, on peut envisager d'autres moyens pour établir le contact, par exemple des vias en saillie au fond de la rainure qui pénètrent dans les fils du toron en plaquant le toron contre le fond de la rainure. Bien que l'on ait décrit une rainure obtenue par assemblage de composants électroniques, on peut également envisager, hors du domaine de l'invention, une rainure réalisée dans la masse de la puce, par exemple par sciage ou par gravure. En outre, dans un mode de réalisation hors de l'invention, la rainure de logement du toron peut être prévue sur n'importe qu'elle face de la puce. De plus, les faces de la puce peuvent être de diverses formes, par exemple planes ou bombées.

## Revendications

1. Assemblage d'au moins une puce microélectronique avec un élément filaire (5), ladite au moins une puce microélectronique comprenant un composant microélectronique (6) séparé d'une contreplaque (7) ou d'un composant microélectronique additionnel (6) par une entretoise (8),
dans lequel l'entretoise (8), le composant microélectronique (6) et la contreplaque (7) ou le composant électronique additionnel (6) définissent au moins une rainure (4) d'encastrement de l'élément filaire (5), la au moins une rainure (4) possédant une première paroi latérale interne (10b) définie par le composant microélectronique (6), un fond (11) défini par l'entretoise (8) et une deuxième paroi latérale interne (10a) opposée à la première paroi latérale interne (10b) et définie par le composant microélectronique additionnel (6) ou la contreplaque (7), la au moins une rainure (4) ayant un axe longitudinal (A₁) parallèle au fond (11) de la rainure (4),
assemblage **caractérisé en ce que** l'élément filaire (5) est un toron d'axe longitudinal sensiblement parallèle à l'axe longitudinal (A₁) de la rainure (4) dans laquelle il est encastré, ledit toron comportant au moins deux fils électriquement conducteurs recouverts d'isolant, et **en ce que** la au moins une puce microélectronique comporte, dans la rainure (4) dans laquelle l'élément filaire (5) est encastré, au moins un plot (9) électriquement conducteur, ledit au moins un plot (9) étant en contact électrique avec une zone dénudée d'un seul des au moins deux fils électriquement conducteurs du toron.

2. Assemblage selon la revendication 1, **caractérisé en ce qu'**il comporte au moins deux puces microélectroniques reliées par le toron, un fil électriquement conducteur du toron étant en contact avec le au moins un plot (9) d'une seule puce microélectronique.

3. Assemblage selon la revendication 1, **caractérisé en ce qu'**il comporte au moins deux puces microélectroniques reliées par le toron et **en ce qu'**un fil électriquement conducteur du toron est en contact avec le au moins un plot (9) de chacune des au moins deux puces.

4. Assemblage selon la revendication 1 , **caractérisé en ce que** ladite puce microélectronique comporte autant de plots (9) que de fils électriquement conducteurs distincts du toron, chaque plot (9) étant en contact électrique avec un fil électriquement conducteur associé du toron.

5. Assemblage selon l'une quelconque des revendication 1 à 4, **caractérisé en ce que** chaque plot (9) est disposé sur au moins une première paroi latérale (10b) de la rainure (4) et constitue des moyens de blocage du toron dans la rainure (4) par pincement du toron entre chaque plot (9) et une seconde paroi latérale (10a) de la rainure opposée audit plot (9).

6. Assemblage selon la revendication 5, **caractérisé en ce que** chaque plot (9) a une forme allongée et est agencé de manière inclinée par rapport à l'axe longitudinal (A₁) de la rainure (4).

7. Procédé pour réaliser un assemblage selon l'une des revendications 5 et 6, **caractérisé en ce qu'**il comporte la formation d'un toron encastré dans la rainure (4), ledit toron étant bloqué par pincement entre chaque plot (9) et la paroi latérale (10a) opposée audit plot (9), et la dénudation d'une zone (12) du fil électriquement conducteur du toron destiné à venir en contact avec le plot (9) correspondant.

8. Procédé selon la revendication 7, **caractérisé en ce que** la dénudation est réalisée lors de l'encastrement.

9. Procédé selon la revendication 7, **caractérisé en ce que** la dénudation est réalisée après encastrement par traction du toron selon l'axe longitudinal de la rainure (4).

10. Procédé selon la revendication 7, **caractérisé en ce que** le toron encastré est formé par torsion après insertion des fils le constituant dans la rainure (4), la dénudation et le blocage par pincement étant ensuite réalisés par traction du toron.

## Patentansprüche

1. Baugruppe mit mindestens einem mikroelektronischen Chip und einem Drahtelement (5), wobei dieser mindestens eine mikroelektronische Chip ein mikroelektronisches Bauteil (6) enthält, das durch einen Quersteg (8) von einem Gegenplättchen (7) oder einem zusätzlichen mikroelektronischen Bauteil (6) getrennt ist,
wobei der Quersteg (8), das elektronische Bauteil (6) und das Gegenplättchen (7) oder das zusätzliche mikroelektronische Bauteil (6) mindestens eine Rille (4) zum Einbau des Drahtelements (5) bilden, wobei die mindestens eine Rille (4) eine erste innere Seitenwand (10b), die von dem mikroelektronischen Bauteil (6) gebildet wird, eine Bodenwand (11), die von dem Quersteg (8) gebildet wird, und eine zweite, der ersten inneren Seitenwand (10b) gegenüberliegende innere Seitenwand (10a), die von dem zusätzlichen mikroelektronischen Bauteil (6) oder dem Gegenplättchen (7) gebildet wird, besitzt, wobei die mindestens eine Rille (4) eine Längsachse (A₁) hat, die parallel zu der Bodenwand (11) der Rille (4) verläuft,
**dadurch gekennzeichnet,**
**dass** das Drahtelement (5) eine Litze ist, deren Längsachse im Wesentlichen parallel zu der Längsachse (A₁) der Rille (4) verläuft, in die sie eingebaut ist, wobei die genannte Litze mindestens zwei elektrisch leitende Drähte enthält, die mit Isoliermaterial ummantelt sind, und dass der mindestens eine mikroelektronische Chip in der Rille (4), in der das Drahtelement (5) eingebaut ist, mindestens ein elektrisch leitendes Kontaktstück (9) aufweist, wobei sich dieses mindestens eine Kontaktstück (9) in elektrischem Kontakt mit einem abisolierten Bereich lediglich eines der mindestens zwei elektrisch leitenden Drähte der Litze befindet.

2. Baugruppe nach Anspruch 1,
**dadurch gekennzeichnet,**
**dass** sie mindestens zwei mikroelektronische Chips enthält, die durch die Litze miteinander verbunden sind, wobei sich ein elektrisch leitender Draht der Litze in Kontakt mit dem mindestens einen Kontaktstück (9) lediglich eines mikroelektronischen Chips befindet.

3. Baugruppe nach Anspruch 1,
**dadurch gekennzeichnet,**
**dass** sie mindestens zwei mikroelektronische Chips enthält, die durch die Litze miteinander verbunden sind, und dass sich ein elektrisch leitender Draht der Litze in Kontakt mit dem mindestens einen Kontaktstück (9) jedes der mindestens zwei Chips befindet.

4. Baugruppe nach Anspruch 1,
**dadurch gekennzeichnet,**
**dass** der genannte mikroelektronische Chip ebenso viele Kontaktstücke (9) aufweist wie getrennte elektrisch leitende Drähte in der Litze vorhanden sind, wobei sich jedes Kontaktstück (9) in elektrischem Kontakt mit einem ihm zugeordneten elektrisch leitenden Draht der Litze befindet.

5. Baugruppe nach einem der Ansprüche 1 bis 4,
**dadurch gekennzeichnet,**
**dass** jedes Kontaktstück (9) an mindestens einer ersten Seitenwand (10b) der Rille (4) angeordnet ist und Blockiermittel der Litze in der Rille (4) bildet, indem die Litze zwischen jedem Kontaktstück (9) und einer zweiten Seitenwand (10a) der Rille, die diesem Kontaktstück (9) gegenüber liegt, festgeklemmt wird.

6. Baugruppe nach Anspruch 5,
**dadurch gekennzeichnet,**
**dass** jedes Kontaktstück (9) eine längliche Form hat und gegenüber der Längsachse (A₁) der Rille (4) geneigt angebracht ist.

7. Verfahren zur Herstellung einer Baugruppe nach einem der Ansprüche 5 und 6,
**dadurch gekennzeichnet,**
**dass** es die Bildung einer in die Rille (4) eingebauten Litze beinhaltet, wobei diese Litze durch Festklemmen zwischen jedem Kontaktstück (9) und der Seitenwand (10a), die diesem Kontaktstück (9) gegenüber liegt, arretiert wird, sowie die Abisolierung eines Bereichs (12) des elektrisch leitenden Drahts der Litze, der dazu vorgesehen ist, in Kontakt mit dem entsprechenden Kontaktstück (9) zu kommen, beinhaltet.

8. Verfahren nach Anspruch 7,
**dadurch gekennzeichnet,**
**dass** das Abisolieren beim Einbau erfolgt.

9. Verfahren nach Anspruch 7,
**dadurch gekennzeichnet,**
**dass** das Abisolieren nach dem Einbau durch ziehen der Litze entlang der Längsachse der Rille (4) erfolgt.

10. Verfahren nach Anspruch 7,
**dadurch gekennzeichnet,**
**dass** die eingebaute Litze durch Verdrehen nach dem Einsetzen der sie bildenden Drähte in die Rille (4) gebildet wird, wobei die Abisolierung und die Arretierung durch Festklemmen sodann durch Ziehen der Litze erfolgt.

## Claims

1. Assembly of at least one microelectronic chip with a wire element (5), said at least one microelectronic chip comprising a microelectronic component (6) separated from a counter-plate (7) or from an additional microelectronic component (6) by a spacer (8),
wherein the spacer (8), the electronic component (6) and the counter-plate (7) or the additional microelectronic component (6) define at least one groove (4) for embedding the wire element (5), the at least one groove (4) having a first inner side wall (10b) defined by the microelectronic component (6), a bottom (11) defined by the spacer (8) and a second inner side wall (10a) opposite the first inner side wall (10b) and defined by the additional micro-electronic component (6) or the counter-plate (7), the at least one groove (4) having a longitudinal axis (A₁) parallel to the bottom (11) of the groove (4),
assembly **characterized in that** the wire element (5) is a strand having a longitudinal axis substantially parallel to the longitudinal axis (A₁) of the groove (4) in which it is embedded, said strand comprising at least two electrically conducting wires covered with insulator, and **in that** the at least one microelectronic chip comprises at least one electrically conducting bump (9), in the groove (4) in which the wire element (5) is embedded, said at least one bump (9) being in electric contact with a bared area of only one of the at least two electrically conducting wires of the strand.

2. Assembly according to claim 1, **characterized in that** it comprises at least two microelectronic chips joined by the strand, one electrically conducting wire of the strand being in contact with the at least one bump (9) of one microelectronic chip only.

3. Assembly according to claim 1, **characterized in that** it comprises at least two microelectronic chips joined by the strand and **in that** one electrically conducting wire of the strand is in contact with the at least one bump (9) of each of the at least two chips.

4. The assembly according to claim 1, **characterized in that** said microelectronic chip comprises as many bumps (9) as distinct electrically conducting wires of the strand, each bump (9) being in electric contact with an associated electrically conducting wire of the strand.

5. The assembly according to any one of claims 1 to 4, **characterized in that** each bump (9) is arranged on at least a first side wall (10b) of the groove (4) and constitutes means for blocking the strand in the groove (4) by pinching the strand between each bump (9) and a second side wall (10a) of the groove opposite said bump (9).

6. The assembly according to claim 5, **characterized in that** each bump (9) has an elongate shape and is arranged in inclined manner with respect to the longitudinal axis (A₁) of the groove (4).

7. A method for achieving the assembly according to one of claims 5 and 6, **characterized in that** it comprises formation of a strand embedded in the groove (4,) said strand being blocked by pinching between each bump (9) and the side wall (10a) opposite said bump (9), and stripping of an area (12) of the electrically conducting wire of the strand designed to come into contact with the corresponding bump (9).

8. The method according to claim 7, **characterized in that** stripping is performed at the same time as embedment.

9. The method according to claim 7, **characterized in that** stripping is performed after embedment by traction of the strand along the longitudinal axis of the groove (4).

10. The method according to claim 7, **characterized in that** the embedded strand is formed by torsion after insertion of the wires constituting the strand in the groove (4), stripping and blocking by pinching then being performed by traction of the strand.
